# EUROPÄISCHE PATENTSCHRIFT

(11) **EP 1 890 164 B1**
(45) Veröffentlichungstag und Bekanntmachung des Hinweises auf die Patenterteilung: **10.07.2013**
(21) Anmeldenummer: 07016023.9
(22) Anmeldetag: 15.08.2007
(51) Int. Cl.: H02B 1/03, H02B 1/04, H01H 71/10, G01R 22/06

(54) **Stromzählersystem**
Electricity meter system
Système de compteur de courant

(30) Priorität: 18.08.2006 DE 102006038705; 23.11.2006 DE 102006055322
(43) Veröffentlichungstag der Anmeldung: 20.02.2008
(73) Patentinhaber: ABB AG, 68309 Mannheim (DE)
(72) Erfinder: Eppe, Klaus-Peter, Dipl.-Ing., 69429 Waldbrunn (DE); Wieland, Ralf, Dipl.-Ing., 69429 Waldbrunn (DE); Muders, Erwin, Dipl.-Ing., 69126 Heidelberg (DE); Siedelhofer, Bernd, Dipl.-Ing., 69121 Heidelberg (DE)

(56) Entgegenhaltungen:
- EP-A1- 1 607 752
- DE-A1-102004 054 175
- DE-U1- 20 216 393

## Beschreibung

Die Erfindung betrifft ein Stromzählersystem gemäß dem Oberbegriff des Anspruchs 1, einen Trennschalter zur Verwendung mit einem erfindungsgemäßen Stromzählersystem gemäß dem Anspruch 18, sowie eine Unterbrechungsvorrichtung zur Verwendung mit einem erfindungsgemäßen Stromzählersystem gemäß dem Anspruch 23.

Es gibt derzeit Bestrebungen, die elektromechanischen Haushaltsstromzähler durch elektronische Stromzähler zu ersetzen. Diese elektronischen Haushaltszähler (kurz auch EHZ genannt) besitzen an ihrer Befestigungsseite nach unten herausragende Kontaktfahnen, die ins Innere eines Adapters oder einer Zählertragplatte eingesteckt und dort mit geeigneten Kontakteinrichtungen in elektrisch leitende Verbindung gebracht werden.

Damit der Austausch eines Stromzählers oder der neue Einbau einfach bewerkstelligt werden kann, ohne dass beim Austausch der Strom zu den Verbrauchern unterbrochen wird, werden Adapter vorgesehen, in denen sich Kontakteinrichtungen befinden. Der Stromzähler wird auf den Adapter dergestalt aufgesetzt, dass die Kontaktfahnen durch Schlitze ins Innere des Adapters greifen. Sodann wird der Stromzähler verschoben, wobei gleichzeitig eine elektrische Verbindung innerhalb des Adapters aufgetrennt wird, so dass der Strom, der bei nicht eingebautem Stromzähler über die Kontakteinrichtungen direkt zu den Verbrauchern fließt, nunmehr über den Stromzähler geführt ist.

Ähnliche Ausführungen können auch bei Zählertragplatten in einem Zählerschrank vorgesehen sein.

Insoweit wird unter dem Begriff " Plattform" sowohl ein Adapter zum nachträglichen Einbau in einen Zählerschrank, der ein herkömmliches Zählerkreuz aufweist, als auch eine von vornherein zum Aufsetzen des EHZ vorbereitete Zählertragplatte im Zählerschrank verstanden.

Man unterscheidet bei gattungsgemäßen Plattformen zwischen einer Auslieferungsposition, einer Montageposition und einer Betriebsposition. In der Auslieferungsposition soll es nicht möglich sein, den Stromzähler durch die Schlitze in der Abdeckplatte der Plattform zu stecken. In der Montageposition ist es möglich, den Stromzähler durch die Schlitze in der Abdeckplatte der Plattform zu stecken. Sie sind in dieser Position zunächst noch nicht mit den Kontakteinrichtungen verbunden. Die Kontakteinrichtungen sind untereinander noch durch Überbrückungselemente verbunden, so dass der Strom innerhalb des Adapters von der Eingangs- zur Ausgangsseite über die Kontakteinrichtungen und die Überbrückungselemente geleitet wird, ohne zunächst den Stromzähler zu durchfließen.

In der Arbeitsposition ist der Stromzähler parallel zu der Abdeckplatte der Plattform verschoben, so dass nun die Anschlussfahnen des elektronischen Stromzählers mit den Kontakteinrichtungen in Verbindung stehen und gleichzeitig die Überbrückungselemente so verschoben sind, dass sie die Kontakteinrichtungen nicht mehr überbrücken.

Eine gattungsgemäße Plattform ist beispielsweise aus der DE 10 2004 054 175 A1 bekannt.

Der Vorteil von gattungsgemäßen Plattformen zur Verwendung mit elektronischen Haushaltszählern liegt darin, dass bei einem Wechsel des Haushaltszählers keine Unterbrechung der Stromversorgung in den nachgeschalteten Stromkreisen des Verbrauchers stattfindet. Allerdings bieten gattungsgemäße Plattformen auch Manipulationsmöglichkeiten für den Verbraucher. Insbesondere könnten Verbraucher den elektronischen Haushaltszähler auf der gattungsgemäßen Plattform zumindest zeitweise aus der Betriebsposition in die Montageposition bringen, so dass dann der von ihnen verbrauchte Strom nicht durch den Zähler erfasst würde. Ebenfalls könnten Verbraucher, bei denen der Stromzähler entfernt und die Plattform in den Auslieferungszustand versetzt wurde, und die daher nicht mehr oder noch nicht zum Bezug elektrischer Energie berechtigt sind, die Plattform aus der Auslieferungsstellung in die Montageposition bringen, um so unberechtigterweise Strom aus dem Versorgungsnetz entnehmen zu können, ohne ihn zahlen zu müssen.

Um das zu verhindern, wurden bisher verschiedene Maßnahmen vorgeschlagen, um eine unberechtigte Verschiebung des Stromzählers auf der Plattform zu verhindern. Beispielsweise zeigt die DE 20 2004000 858 eine Stromzähleranordnung mit einem Stromzähler und einem Adapter und mit einer Plombiereinrichtung. Die Plombiereinrichtung weist eine Plombierstange auf, deren freies Ende einen Gewindeabschnitt aufweist, der an einen am Adapter angebrachten Innengewindeabschnitt einschraubbar ist. Durch die Plombiereinrichtung soll verhindert werden, dass der Verbraucher unberechtigt den Stromzähler auf der Plattform verschiebt. Allerdings kann durch solche Plombiersysteme der Verbraucher nicht wirksam genug von Missbrauch abgehalten werden. Er könnte die Plombiereinrichtung unberechtigterweise entfernen und danach den Stromzähler in die Montageposition verbringen und kostenlos Strom entnehmen, was ihm im Zweifel und im Nachhinein nicht mehr nachzuweisen ist.

Die EP 1 607 752 A1 zeigt einen Überwachungszähler zum Steuern der Versorgung von Diensten, besonders der Bereitstellung von elektrischer Energie, wobei der Überwachungszähler umfasst: eine Trägerbasis, verankert mit dem, was eine Hauptleistungsversorgungsleitung ist, und eine Zählgruppe, welche trennbar ist von der Trägerbasis und eine Zählvorrichtung umfasst, die zwischengeschaltet ist zwischen der Hauptleistungsversorgungsleitung und einer Teilnehmerleitung; ein Anfügungssystem vom Bajonett-Typ zum Anbringen und Abnehmen der Zählgruppe an/von der Trägerbasis durch parallele Bewegung der Zählgruppe relativ zu der Trägerbasis; eine Sicherheitsverankerung, umfassend: mechanische Mittel assoziiert mit der Zählgruppe und beweglich in eine Verschlussposition, zum Kuppeln mit der Trägerbasis, wenn die Zählgruppe auf der Trägerbasis angebracht ist; und einen Unterbrecher zum Erzeugen eines Aktivierungssignals bei Aktivierung des mechanischen Mittels, wobei das mechanische Mittel angeordnet ist, um den Unterbrecher zu aktivieren, wenn das mechanische Mittel von der Verschlussposition freigegeben wird zum Abnehmen der Zählgruppe von der Trägerbasis; wobei das mechanische Mittel einen Halteschlüssel umfasst, der beweglich ist in ein Haltemittel in der Trägerbasis in der Verschlussposition, um einen Schließstab gegen parallele Bewegung der Zählgruppe des Überwachungszählers relativ zu der Trägerbasis zu bilden; das mechanische Mittel einen Schließstabdorn umfasst, der mit dem Halteschlüssel und dem Unterbrecher der Sicherheitsverankerung zusammenarbeitet, so dass die Blockier-/ Unblockier-Bewegung des Schließstabdorns der Öffnen-/Schließen-Bewegung des Unterbrechers entspricht; und der Schließstabdorn koaxial zu dem Halteschlüssel angeordnet ist und der Schließstabdorn, wenn das mechanische Mittel in der Verschlussposition ist, gegen einen Sitz der Trägerbasis gedrängt wird, um einen Schließstab gegen die parallele Bewegung der Zählgruppe relativ zu der Trägerbasis zu bilden.

Es ist daher die Aufgabe der vorliegenden Erfindung, ein gattungsgemäßes Stromzählersystem so weiterzuentwickeln, dass eine unbefugte Stromentnahme wirksam verhindert wird, wenn die Plombiereinrichtung zwischen Zähler und Plattform entfernt wurde.

Die Aufgabe wird gelöst durch ein gattungsgemäßes Stromzählersystem mit den kennzeichnenden Merkmalen des Anspruchs 1.

Erfindungsgemäß also umfasst das Stromzählersystem eine Unterbrechungsvorrichtung, die so mit der Aufnahmeplattform zusammenwirkt, dass bei Verschiebung des Zählers auf der Aufnahmeplattform aus der Betriebsposition in die Montageposition die Stromzufuhr zu der Aufnahmeplattform durch die Unterbrechungsvorrichtung bleibend unterbrochen wird.

Gemäß einer vorteilhaften Ausführungsform der Erfindung umfasst die Unterbrechungsvorrichtung einen Trennschalter mit einem Schaltgriff zum manuellen Ein - und Ausschalten des Trennschalters, sowie mit einer Verklinkungsstelle.

Durch ein solches erfindungsgemäßes Stromzählersystem ist also in jedem Fall sichergestellt, dass der Endverbraucher nicht unberechtigt Strom entnehmen kann, auch dann nicht, wenn er eine etwa vorhandene Plombiereinrichtung zwischen den Zähler und der Plattform entfernt haben sollte. Denn sobald er den Zähler unberechtigterweise aus der Betriebsposition in die Montageposition schiebt, wird die Stromzufuhr zu der Aufnahmeplattform und damit zum Zähler und damit auch zu den nachgelagerten Stromkreisen unterbrochen.

Vorteilhafterweise umfasst die Aufnahmeplattform dabei eine Verschiebeerkennungsvorrichtung, und die Unterbrechungsvorrichtung umfasst eine Zwangsauslösevorrichtung, die durch die Verschiebeerkennungsvorrichtung aus einer Einschalt - in eine Ausschaltstellung verbringbar ist, und die mit der Verklinkungsstelle des Trennschalters so zusammenwirkt, dass diese in der Ausschaltstellung der Zwangsauslösevorrichtung entklinkt ist.

In einer besonders vorteilhaften Ausführungsform ist die Unterbrechungsvorrichtung so eingerichtet, dass die Unterbrechung der Stromzufuhr nur mithilfe spezieller Rücksetzmittel aufgehoben werden kann. Über diese speziellen Rücksetzmittel verfügt der Endverbraucher nicht. Er muss daher in diesem Fall, wenn er wieder Strom beziehen möchte, seinen Energieversorger benachrichtigen, damit dieser autorisiertes Personal mit dem speziellen Rücksetzmittel schickt, damit die Unterbrechung der Stromzufuhr wieder behoben werden kann. Doch damit wird der Betrugsversuch offenbar und der Energieversorger kann geeignete Sanktionen gegen den Verbraucher einleiten.

In einer weiterhin besonders vorteilhaften Ausgestaltungsform ist der Trennschalter so eingerichtet, dass er bei durch die Zwangsauslösevorrichtung entklinkter Verklinkungsstelle geöffnet ist und sich durch den Schaltgriff nicht mehr schließen lässt.

Als erfindungsgemäßer Trennschalter kann dabei insbesondere ein Sicherungshauptschalter verwendet werden. Die Verwendung eines Sicherungshauptschalters hat den weiteren Vorteil, dass ein solcher normalerweise in dem Zählerplatz bereits vorhanden ist, nämlich zwischen dem Hausanschlusskasten und dem Zählereingang.

Es kann in vorteilhafter Weise aber auch als Trennschalter ein Leitungsschutzschalter infrage kommen.

Gemäß einer sehr vorteilhaften Ausführungsform umfasst die Unterbrechungsvorrichtung eine Zwangsauslösevorrichtung, die durch die Verschiebeerkennungsvorrichtung aus einer Einschalt- in eine Ausschaltstellung verbringbar ist, und die mit der Verklinkungsstelle des Trennschalters so zusammenwirkt, dass diese in der Ausschaltstellung der Zwangsauslösevorrichtung entklinkt ist. Dabei kann die Zwangsauslösevorrichtung ein Arbeitsstromauslöser sein, dessen Arbeitsstrom - Auslösehebel, auch als Auslösefinger bezeichnet, mit der Verklinkungsstelle des Trennschalters zusammenwirkt. Nach Auslösung ist der Arbeitsstromauslöser dann nur mit einem Spezialwerkzeug manuell rücksetzbar. Solange die Zwangsauslösevorrichtung sich in der Ausschaltstellung befindet, ist daher ein manuelles Wiedereinschalten des Trennschalters, also beispielsweise des Sicherungshauptschalters, nicht möglich. Erst wenn die Zwangsauslösevorrichtung mittels des Spezialwerkzeuges zurückgesetzt wurde, also wieder in die Einschaltstellung verbracht wurde, kann die Verklinkungsstelle des Trennschalters wieder verklinken und der Trennschalter damit wieder eingeschaltet werden.

Alternativ kann die Zwangsauslösevorrichtung auch ein Stellantrieb sein, dessen angetriebene Achse mit der Verklinkungsstelle des Trennschalters zusammenwirkt.

Gemäß einer möglichen Ausführungsform umfasst die Verschiebeerkennungsvorrichtung einen Endschalter, der so angeordnet ist; dass er ein Verschiebeerkennungssignal an die Unterbrechungsvorrichtung abgibt, wenn der Stromzähler aus der Betriebsposition in die Montageposition verbracht ist. Die Verschiebeerkennungsvorrichtung kann aber auch eine Lichtschranke umfassen, die so angeordnet ist, dass sie ein Verschiebeerkennungssignal an die Unterbrechungsvorrichtung abgibt, wenn der Stromzähler aus der Betriebsposition in die Montageposition verbracht ist.

Ein erfindungsgemäßer Endschalter oder eine erfindungsgemäße Lichtschranke können an verschiedenen Stellen in der Plattform eingebaut werden, da gattungsgemäße Plattformen über genügend freien Raum unterhalb der Abdeckplatte verfügen. Beispielsweise kann ein erfindungsgemäßer Endschalter unterhalb der Abdeckplatte so eingebaut sein, dass Befestigungskrallen, die an jedem Stromzähler vorhanden sind, um ihn in der Betriebsposition in Befestigungsschlitzen auf der Adapterplatte zu halten, den Endschalter auslösen, wenn er aus der Betriebsposition in die Montageposition verschoben wurde.

Günstig ist weiterhin eine Ausführungsform, bei der die Verschiebeerkennungsvorrichtung eine Verzögerungsschaltung umfasst, so dass das Verschiebeerkennungssignal mit einer vorgebbaren zeitlichen Verzögerung, nachdem der Stromzähler aus der Betriebsposition in die Montageposition verbracht wurde, an die Unterbrechungsvorrichtung abgegeben wird. Diese Variante ist insbesondere dann günstig, wenn der Stromzähler von autorisiertem Personal ausgebaut wird, beispielsweise im Zuge des vorgeschriebenen turnusmäßigen Auswechselns des Stromzählers. Wenn dann die zeitliche Verzögerung beispielsweise auf einen Zeitraum von einigen Minuten eingestellt ist, hat der Monteur genügend Zeit, um den Stromzähler zu wechseln, ohne dass der Sicherungshauptschalter die Stromzufuhr unterbricht. Nur wenn der Verbraucher unberechtigterweise den Stromzähler verschiebt, wird diese verschobene Position für einen längeren Zeitraum eingehalten werden, da der Verbraucher über einen längeren Zeitraum kostenlosen Strom beziehen möchte. Erst wenn nach Ablauf der eingestellten Verzögerungszeit der Stromzähler sich nicht wieder in der Betriebsposition befindet, wird die Stromzufuhr durch die Unterbrechungsvorrichtung unterbrochen.

Eine weitere Ausgestaltungsmöglichkeit der Erfindung besteht darin, dass über eine Fernwirkeinrichtung das Verschiebeerkennungssignal an einen entfernten Ort und von dem entfernten Ort ein Unterbrechungssignal an die Unterbrechungsvorrichtung übertragbar sind. Als Fernwirkeinrichtung kann beispielsweise eine bekannte Modemverbindung über die Telefonleitung benutzt werden. Auf diese Weise kann ein unbefugtes Verschieben des Stromzählers in einer entfernt liegenden Überwachungsstation des Energieversorgers erkannt werden, und die Zwangsabschaltung der Stromversorgung des manipulierenden Verbrauchers kann von dieser Überwachungsstation auch initiiert werden.

Ein erfindungsgemäßer Trennschalter zur Verwendung in einem erfindungsgemäßen Stromzählersystem hat einen Schaltgriff zum manuellen Ein - und Ausschalten des Trennschalters, und eine Verklinkungsstelle, wobei bei entklinkter Verklinkungsstelle der Trennschalter geöffnet ist und sich durch den Schaltgriff nicht mehr schließen lässt. Weiterhin hat er einen drehbar gelagerten Auslösehebel, der von einer Verklinkungs- in eine Entklinkungsstellung bringbar ist und in der Entklinkungsstellung die Verklinkungsstelle entklinkt, und der Auslösehebel weist in seiner Drehachse eine Hohlwelle auf, in die ein zwischen einer Ruhe - und einer Auslöseposition drehbarer Auslösefinger des Zwangsauslösers so einführbar ist, dass der Auslösehebel des Trennschalters in der Auslöseposition des Auslösefingers in der Entklinkungsstellung gehalten ist.

Dabei korrespondieren die Innenkontur der Hohlwelle und die Außenkontur des Auslösefingers vorteilhafterweise so miteinander, dass der Auslösefinger des Zwangsauslösers bei Verdrehen zwischen seiner Ruhe - und seiner Auslöseposition den Auslösehebel in Richtung von dessen Entklinkungsstellung mitnimmt.

Besonders vorteilhaft korrespondieren die Innenkontur der Hohlwelle und die Außenkontur des Auslösefingers so miteinander, dass der Auslösehebel zwischen seiner Ver- und Entklinkungsstellung bewegbar ist, auch wenn der Auslösefinger des Zwangsauslösers sich in seiner Ruheposition befindet. Wenn dann als Trennschalter beispielsweise ein Sicherungshauptschalter verwendet wird, behält er seine bestimmungsgemäße selektive Auslösefunktion bei. Wenn der als Trennschalter verwendete Sicherungshauptschalter also bestimmungsgemäß selektiv einen Überstrom ausschaltet, dann wirkt der thermische Auslöser des Sicherungshauptschalters auf den Auslösehebel und verdreht ihn in die Entklinkungsstellung. Bei einem erfindungsgemäßen Trennschalter ist dies möglich, ohne dass dadurch der Auslösefinger des Zwangsauslösers beeinflusst wird.

Bei einer möglichen, besonders vorteilhaften Realisierung eines erfindungsgemäßen Trennschalters weist die Hohlwelle radial nach innen weisende und sich radial gegenüberstehende Zapfen mit je einer ersten und einer zweiten, sich in Umfangsrichtung der Hohlwelle gegenüberliegende Anlagefläche auf, und der Auslösefinger des Zwangsauslösers hat in etwa die Form eines längs erstreckten Balkens. Der Auslösefinger des Zwangsauslösers tritt beim Verdrehen zwischen der Ruhe - und Auslöseposition mit der ersten Anlagefläche der Zapfen in kraftschlüssige Verbindung, und zwischen der zweiten Anlagefläche jedes Zapfens und dem Auslösefinger besteht in Umfangsrichtung der Hohlwelle ein freier Raum, in dem sich der Zapfen relativ zu der Hohlwelle bewegen kann, wenn der Auslösehebel nicht durch den Zwangsauslöser, sondern beispielsweise durch den thermischer Auslöser bewegt wird.

Eine erfindungsgemäße Unterbrechungsvorrichtung zur Verwendung mit einem erfindungsgemäßen Stromzählersystem umfasst einen Trennschalter mit einem Schaltgriff zum manuellen Ein - und Ausschalten des Trennschalters, und eine Verklinkungsstelle, wobei bei entklinkter Verklinkungsstelle der Trennschalter geöffnet ist und sich durch den Schaltgriff nicht mehr schließen lässt, sowie einen drehbar gelagerten Auslösehebel, der von einer Verklinkungs- in eine Entklinkungsstellung bringbar ist und in der Entklinkungsstellung die Verklinkungsstelle entklinkt, wobei der Auslösehebel in seiner Drehachse eine Hohlwelle aufweist. Weiterhin umfasst eine erfindungsgemäße Unterbrechungsvorrichtung einen Zwangsauslöser mit einem zwischen einer Ruhe- und einer Auslöseposition drehbaren Auslösefinger, wobei der Trennschalter und der Zwangsauslöser aneinander gereiht sind, so dass der Auslösefinger in die Hohlwelle des Auslösehebels eingreift und so mit dieser zusammenwirkt, dass der Auslösehebel des Trennschalters in der Auslöseposition des Auslösefingers in der Entklinkungsstellung gehalten ist.

Dabei kann der Trennschalter ein einpoliger Sicherungshauptschalter und der Zwangsauslöser ein Arbeitsstromauslöser sein. Der Vorteil dieser Ausführungsform liegt darin, dass ein Sicherungshauptschalter üblicherweise im Zählerkasten bereits vorhanden ist, und ein Arbeitsstromauslöser ein standardisiertes Serienbauteil ist. Der Aufbau dieser Ausführungsform ist also besonders einfach und günstig. Es muss die Welle des Auslösehebels im Sicherungshauptschalter in der Art modifiziert werden, dass diese Welle eine Hohlwelle mit den oben beschriebenen strukturellen und funktionellen Merkmalen wird.

Der Trennschalter kann auch ein aus mehreren, beispielsweise drei, aneinander gereihten Einzelpolen gebildeter mehrpoliger Sicherungshauptschalter und der Zwangsauslöser ein Arbeitsstromauslöser sein. Ein so gebildeter mehrpoliger Sicherungshauptschalter hat für jeden Pol ein eigenes Schaltgerät mit einem Auslösehebel und einer Verklinkungsstelle. Der Auslösefinger des Zwangsauslösers ist dann so gestaltet, dass er mit den Hohlwellen in den Auslösehebeln jedes einzelnen Gerätes zusammenwirkt.

Der Trennschalter kann auch ein einzelner, mehrpoliger Sicherungshauptschalter und der Zwangsauslöser ein Arbeitsstromauslöser sein. Ein so gebildeter mehrpoliger Sicherungshauptschalter hat innerhalb eines Gerätes für jeden Pol einen Auslösehebel und eine Verklinkungsstelle. Die Auslösehebel der einzelnen Pole sind dabei intern miteinander verbunden, so dass bei Auslösung auch nur eines Poles nach und nach die anderen Pole mit ausgeschaltet werden. Man spricht von Kaskadierung der Pole. Es genügt daher in diesem Fall, dass der Auslösefinger des Zwangsauslösers mit der Hohlwelle nur eines der Pole zusammenwirkt.

Der Trennschalter kann aber auch ein ein- oder mehrpoliger oder ein aus mehreren aneinander gereihten Polen gebildeter mehrpoliger Leitungsschutzschalter und der Zwangsauslöser ein Arbeitsstromauslöser sein.

Ebenso ist es denkbar, dass der Trennschalter ein ein- oder mehrpoliger oder ein aus mehreren aneinandergereihten Polen gebildeter mehrpoliger Sicherungshauptschalter oder Leitungsschutzschalter und der Zwangsauslöser ein Schrittmotor ist.

Weitere vorteilhafte Ausgestaltungen und Verbesserungen der Erfindung und weitere Vorteile sind den weiteren Unteransprüchen zu entnehmen.

Anhand der Zeichnungen, in denen zwei Ausführungsbeispiele der Erfindung dargestellt sind, sollen die Erfindung sowie weitere vorteilhafte Ausgestaltungen und Verbesserungen der Erfindung näher erläutert und beschrieben werden.

Es zeigen:
- Figur 1: ein erfindungsgemäßes Stromzählersystem in schematischer Darstellung,
- Figur 2: eine schematische Innenansicht einer Aufnahmeplattform mit einem erfindungsgemäßen Trennschalter,
- Figur 3: eine schematische Ansicht eines erfindungsgemäßen Trennschalters, wobei der Auslösehebel in Verklinkungsstellung ist,
- Figur 4: eine schematische Ansicht eines erfindungsgemäßen Trennschalters, wobei der Auslösehebel in Entklinkungsstellung ist,
- Figur 5: eine schematische Darstellung einer erfindungsgemäßen Unterbrechungsvorrichtung mit einem aus drei aneinander gereihten Einzelpolen gebildeten dreipoligen Sicherungshauptschalter und einem Arbeitsstromauslöser, sowie
- Figur 6: eine schematische Darstellung einer zweiten Ausführungsform der Erfindung.

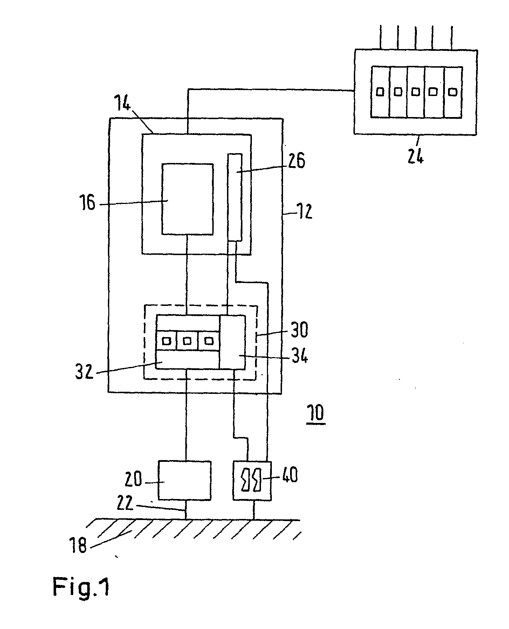

Figur 1 zeigt also schematisch ein Stromzählersystem 10, welches beispielsweise in dem Hausanschlussraum eines Wohnhauses angeordnet ist.

Aus der Hauswand 18 kommt die Hausanschlussleitung 22 heraus und führt zum Hausanschlusskasten 20. Von dort führt eine Leitungsverbindung zu dem Zählerkasten 12.

In dem Zählerkasten 12 ist auf einer Plattform 14 ein elektronischer Stromzähler 16 angeordnet. Zwischen dem Hausanschlusskasten und dem Stromzähler 16 ist ein aus drei aneinander gereihten Einzelpolen gebildeter dreipoliger Sicherungshauptschalter 32 vorgesehen.

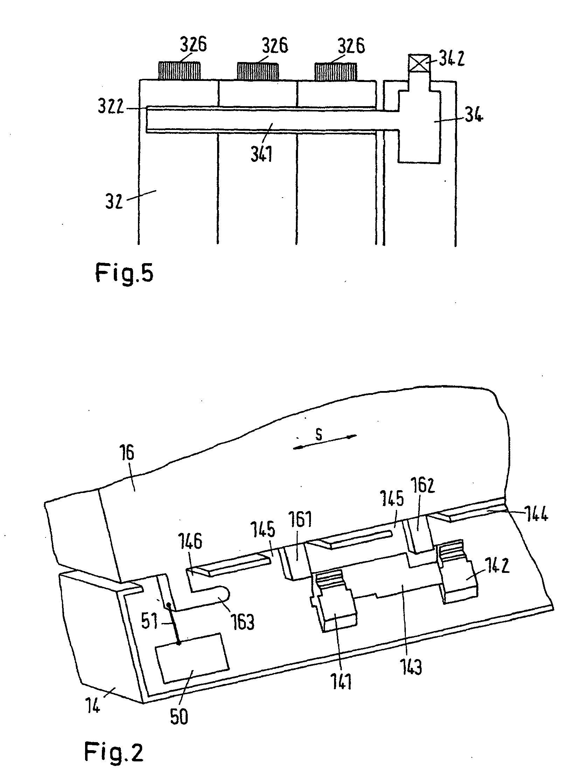

In der Plattform 14 ist eine Verschiebeerkennungsvorrichtung 26 zum Erkennen einer Verschiebung des Stromzählersystems angebracht. Diese kann beispielsweise durch einen Endschalter 50, siehe Figur 2, realisiert sein.

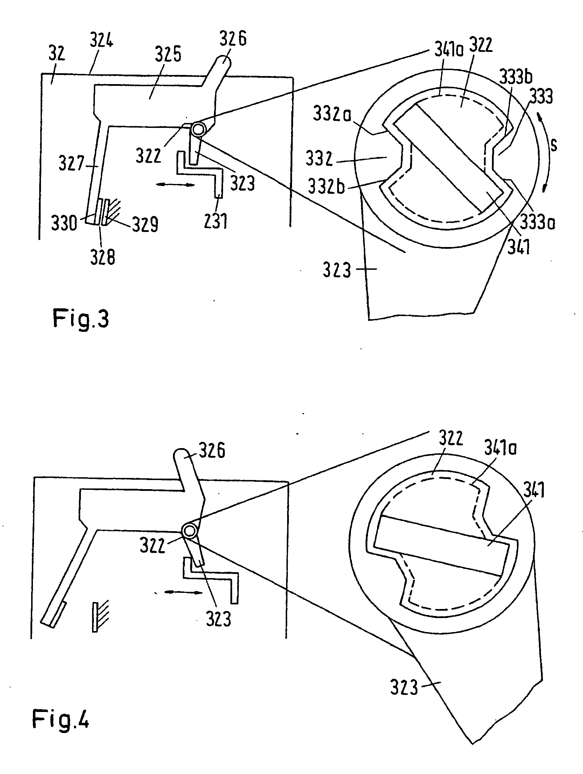

An den dreipoligen Sicherungshauptschalter 32 ist ein Zwangsauslöser 34, hier ein Arbeitsstromauslöser, seitlich angereiht. Der Auslösefinger 341, siehe Figur 5, des Arbeitsstromauslösers 34, ist durch die Hohlwelle 322 des Auslösehebels 323 jedes Pols des dreipoligen Sicherungshauptschalters 32 geführt und korrespondiert so mit dieser, dass bei Verdrehen des Auslösefingers 341 aus seiner Ruheposition in die Auslöseposition der Auslösehebel 323 aus seiner Verklinkungsstellung, siehe Figur 3, in seine Entklinkungsstellung, siehe Figur 4, bewegt wird.

Sein Unterbrechungssignal erhält der Arbeitsstromauslöser 34 über eine Verbindungsleitung von dem Endschalter 50 beziehungsweise der Verschiebeerkennungsvorrichtung 26.

Nachgeordnet zu dem Stromzähler befindet sich der Stromkreisverteiler 24 mit den weiteren Leitungsschutzschaltern, von denen die einzelnen Stromkreise des Hauses versorgt und überwacht werden.

Der dreipoligen Sicherungshauptschalter 32 und der Arbeitsstromauslöser 34 können als eine gemeinsame Unterbrechungsvorrichtung 30 betrachtet werden.

Figur 1 zeigt als Alternative zur direkten Verbindung des Endschalters mit dem Arbeitsstromauslöser die Verbindung des Endschalters 50 beziehungsweise der Verschiebeerkennungsvorrichtung 26 über eine Fernwirkeinrichtung 40 mit einer entfernt gelegenen Überwachungsstation. Als Fernwirkeinrichtung 40 kommt beispielsweise ein Modemanschluss über die Telefonleitung infrage, wie er in Häusern oft bereits realisiert ist. Entsprechend kann der Arbeitsstromauslöser dann sein Unterbrechungssignal auch über die Fernwirkeinrichtung 40 von der entfernt gelegenen Überwachungsstation erhalten.

Insbesondere kann die Fernwirkeinrichtung 40 ein adressierbares und individuell ansprechbares, bidirektional wirkendes Zusatzgerät sein. Dieses kann auch im Zählerplatz 12 mit eingebaut sein.

Beim Einsatz von elektronischen Elektrizitätszählern ist oftmals auch im Zähler selbst bereits eine Zähler-Kommunikationseinheit integriert, die eine bidirektionale, adressierbare und individuell ansprechbare Schnittstelle zu einer entfernt gelegenen Überwachungseinrichtung bildet. Eine solche in dem elektronischen Zähler bereits integrierte Zähler-Kommunikationseinheit kann auch als Fernwirkeinrichtung 40 im Sinne der vorliegenden Erfindung verstanden werden.

Das von der Verschieberkennungsvorrichtung 26 im Falle einer versuchten Manipulation erzeugte Unterbrechungssignal kann in einer weiteren Variante der vorliegenden Erfindung auch über die Zähler-Kommunikationseinheit beziehungsweise die Fernwirkeinrichtung 40 ergänzend zu der Unterbrechung des Strompfades mittels der Unterbrechungsvorrichtung 30 oder auch ohne Unterbrechung des Strompfades an die entfernt gelegene Überwachungsstation gemeldet werden. Damit wird als weitere Funktionalität des erfindungsgemäßen Stromzählersystems eine vom Endkunden unbemerkte Überwachung des Zählerplatzes auf einen Manipulationsversuch hin möglich. Das Energieversorgungsunternehmen kann dann bereits entsprechend reagieren, bevor ein größerer Schaden entsteht oder bevor der manipulierende Endkunde die Spuren seines Tuns verwischt.

Figur 2 zeigt beispielhaft und schematisch eine Möglichkeit, eine Verschiebeerkennungsvorrichtung in Gestalt eines Endschalters 50 in der Plattform vorzusehen. Der Stromzähler 16 ist auf dem Adapter 14 in der Montagestellung zu sehen. Die Abdeckplatte des Adaptergehäuses 144 weist Kontaktschlitze 145 und Befestigungsschlitze 146 auf. Durch die Kontaktschlitze 145 greifen Kontaktfahnen 161, 162 des Stromzählers 16. Durch die Befestigungsschlitze 146 greifen Befestigungskrallen 163, die an der Befestigungsseite des Stromzählers 16 angebracht sind.

Die Kontaktvorrichtungen 141, 142 sind in der in Figur 2 gezeigten Montageposition durch eine Brücke 143 überbrückt. Der Strom fließt in dieser Position nicht durch die Kontaktfahnen 161,162 des Zählers 16, denn diese sind in der gezeigten Position nicht im Kontakt mit den Kontakteinrichtungen 141,142. Somit wird der Stromverbrauch in der gezeigten Position nicht von dem Zähler 16 erfasst. Diese Stellung darf nur bei der Montage des Stromzählers und auch nur von autorisierten Personen und nur für eine sehr kurze Zeit von typischerweise wenigen Minuten angenommen werden.

In dem freien Raum zwischen dem Boden des Adaptergehäuses 144 und einer Seitenwand ist ein Endschalter 50 angebracht. Dieser weist einen Kontakthebelarm 51 auf. Er ist so angebracht, dass in der gezeigten Montageposition der Kontakthebelarm 51 von einer Befestigungskralle 163, die an der Befestigungsseite des Stromzählers 16 angebracht ist, betätigt wird und damit der Endschalter ein Unterbrechungssignal abgibt.

Um das berechtigte Austauschen des Zählers zu ermöglichen, umfasst der Endschalter ein Verzögerungsglied (nicht dargestellt). Dieses bewirkt, dass der Endschalter das Unterbrechungssignal erst einige Zeit, typischerweise einige Minuten, nach Betätigung des Kontakthebelarmes 51 durch die Befestigungskralle 163 abgibt, und somit ein befugtes Austauschen des Zählers ermöglicht wird.

Wie in Figur 5 schematisch dargestellt, ist an den Zwangsauslöser 34 eine Rückstellungsvorrichtung 342 angebracht, mit der allein der Zwangsauslöser 34 nach Auslösung in seine Ruheposition zurückgestellt werden kann. Diese Rückstellungsvorrichtung 342 ist so gestaltet, dass sie nur mit einem speziellen Werkzeug betätigt werden kann, über welches nur das autorisierte Fachpersonal der Stromversorger verfügt. Beispielsweise kann die Rückstellungsvorrichtung 342 einen besonders geformten Schlitz aufweisen, der den Eingriff nur eines ebenfalls besonders geformten, passenden Werkzeugs erlaubt.

Die Figur 3 zeigt auf der linken Seite sehr vereinfacht und schematisch einen Trennschalter 32 mit einem Gehäuse 324. Der Trennschalter 32 umfasst ein Schaltwerk 325 mit einem Schaltgriff 326. Das Schaltwerk 325 verfügt über eine - hier nicht dargestellte - Verklinkungsstelle, die in der Darstellung nach Figur 3 verklinkt ist.

Die Kontaktstelle 328, gebildet aus dem an dem Kontakthebelarm 327 gelagerten beweglichen Kontaktstück 330 und dem festen Kontaktstück 329, ist geschlossen.

Zur Ver- und Entklinkung der Verklinkungsstelle dient der Auslösehebel 323, der in Figur 3 in seiner Verklinkungsstellung gezeigt ist. Dieser kann von einem Auslöseschieber 331 in seine Entklinkungsstellung verbracht werden. Der Auslöserschieber 331 kann dabei von einem weiteren internen Auslöser, beispielsweise im Falle des Sicherungshauptschalters von dem thermischen oder selektiven Auslöser, betätigt werden.

Der Auslösehebel 323 ist an einer Hohlwelle 322 drehbar gelagert. Die Hohlwelle 322 bildet damit die Drehachse des Auslösehebels 323.

Die vergrößerte Detailansicht auf der rechten Seite der Figur 3 zeigt die Gestaltung der Hohlwelle 322 und die Wechselwirkung der Hohlwelle 322 mit dem Auslösefinger 341 des Zwangsauslösers 34.

Die Hohlwelle 322 weist zwei radial nach innen weisende und sich radial gegenüberstehende Zapfen 332, 333 auf. Jeder Zapfen hat eine erste und eine zweite Anlagefläche 332a, 333a; 332b, 333b. Die ersten und zweiten Anlageflächen 332a, 333a; 332b, 333b liegen sich in Umfangsrichtung der Hohlwelle gegenüber.

Der Auslösefinger 341 des Zwangsauslösers 34 hat in etwa die Form eines längserstrecken Balkens mit einer rechteckigen Querschnittkontur. In der Figur 3 ist der Auslösefinger 341 in seiner Ruheposition dargestellt. Zwischen den zweiten Anlageflächen 332b, 333b und dem Auslösefinger ist ein Freiraum vorhanden. Der Auslösehebel 323 kann also in Richtung seiner Entklinkungsstellung verschwenkt werden, ohne dabei von dem Auslösefinger 341 beeinflusst zu sein. Er hat in dieser Richtung gewissermaßen einen Freilauf.

Wenn aber der Auslösefinger 341 sich aus seiner Ruheposition gemäß Figur 3 in seine Auslöseposition gemäß Figur 4 bewegt, so nimmt er durch kraftschlüssige Verbindung mit den ersten Auflageflächen 333a und 332a den Auslösehebel 323 zwangsweise in dessen Entklinkungsstellung mit.

Da der Zwangsauslöser 34 so konzipiert ist, dass der Auslösefinger 341 in der Auslöseposition fest verbleibt, solange, bis er durch die Rückstellungsvorrichtung 342 wieder zurückgesetzt wird, hält der Auslösefinger 341 somit also den Auslösehebel 323 dauernd in seiner Entklinkungsstellung fest.

In der Entklinkungsstellung des Auslösehebels 323 kann die Verklinkungsstelle auch nicht mehr durch den Schaltgriff 326 wieder verklinkt werden. Die Kontaktstelle 328 bleibt also dauerhaft geöffnet.

Anstelle der Zapfen 332, 333 können natürlich auch andere, gleichwirkende Konturelemente, wie beispielsweise Bänder, Balken, längserstreckte Auswölbungen, Nocken oder ähnliches verwendet werden.

Die strichlierte Linien in Figur 3 und 4 zeigt eine Variante für die Gestaltung der Wechselwirkung des Auslösefingers 341 a mit dem Inneren der Hohlwelle 322. Bei dieser Variante steht der Auslösefinger 341 a beidseitig in formschlüssiger Verbindung mit den Zapfen 333, 332 der Hohlwelle 322. Ein Freilauf der Hohlwelle 322 und damit des Auslösehebels 323 in der Ruheposition des Auslösefingers 341 a, ist hier nicht mehr möglich.

Bei den in den Figuren 1, 2,5 gezeigten Ausführungsbeispielen erfolgt die Verbindung zwischen der Verschiebeerkennungsvorrichtung 26 und der Unterbrechungsvorrichtung 30, insbesondere mit dem Zwangsauslöser 34, in Form eines elektrischen Signals über eine elektrische Leitung.

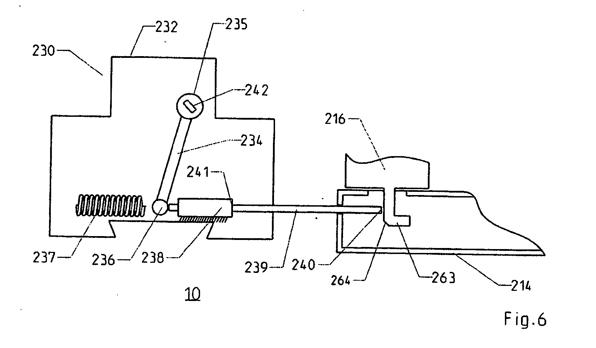

Eine weitere mögliche Ausgestaltungsform der Erfindung zeigt die Figur 6, bei der eine mechanische Kopplung zwischen der Aufnahmeplattform 214 und der Unterbrechungsvorrichtung 230 besteht.

Die Unterbrechungsvorrichtung 230 gemäß der Figur 6 umfasst wieder einen Trennschalter 232. Die Aufnahmeplattform und der Trennschalter 232 sind durch eine mechanische Koppelstange 239 verbunden. Diese ragt mit ihren freien Ende 240 in den freien Raum innerhalb der Aufnahmeplattform 214 in der Nähe einer Befestigungskralle 263 des Stromzählers 216 , und mit ihrem anderen Ende 241 ragt sie in den Trennschalter 232 hinein und wirkt dort mit einem mechanischen Dämpfungsglied 238 zusammen. Sie ist verschieblich gelagert, und so angeordnet, dass sie bei einer Verschiebung des Stromzählers 216 aus seiner Betriebsposition in die Montageposition die Verschiebebewegung des Stromzählers 216 auf das mechanische Dämpfungsglied 238 überträgt. Das mechanische Dämpfungsglied 238 wirkt als Verzögerungsglied und gibt die Bewegung der Koppelstange 239 zeitverzögert an das freie Ende 236 eines Zwangsauslösehebels 234 in dem Trennschalter 216 weiter. Mechanische Dämpfungsglieder diese Art sind im Prinzip bekannt; es handelt sich beispielsweise um hydraulische Bälge, in deren Innerem eine Hydraulik-Flüssigkeit durch eine Blende hindurch verschoben wird, oder andere, funktional entsprechend wirkende Elemente.

Der Zwangsauslöserhebel 234 ist an einer Zwangsauslöserwelle 235 drehbar gelagert, welche einen (nicht dargestellten) Auslösefinger besitzt, der durch die Hohlwelle des Auslösehebels des Trennschalters 232 geführt ist, ähnlich wie in der Figur 5 dargestellt.

Auch die weitere Funktion der Vorrichtung gemäß der Figur 6 entspricht derjenigen, wie sie weiter oben im Zusammenhang mit den Figuren 5, 3,4 bereits beschrieben wurde. Der Unterschied zwischen der Anordnung gemäß der Figur 6 und der Anordnung gemäß der Figuren 3, 4,5 besteht im wesentlichen darin, dass anstelle eines Arbeitsstromauslösers oder eines Schrittmotors, die beide über elektrische Signale angesteuert werden, der Zwangsauslöserhebel 234 durch rein mechanische Kopplung mit der Plattform 214 die Entklinkung der Verklinkungsstelle des Trennschalters 232 bewirkt.

Die Zwangsauslöserwelle 235 weist als Rückstellvorrichtung einen Schlitz 242 auf, der so gestaltet ist, dass er von außerhalb des Trennschalters 232 nur mit einem speziellen Werkzeug betätigt werden kann, über welches nur das autorisierte Fachpersonal der Stromversorgung verfügt.

Auf der dem Dämpfungsglied 238 entgegengesetzten Seite des freien Endes 236 des Zwangsauslösehebels 234 ist eine Rückstellfeder 237 angebracht. Diese wird zusammengedrückt, wenn der Zwangsauslöserhebel 234 durch das Dämpfungsglieder 238 in Entklinkungsrichtung verschwenkt wird. Die Rückstellfeder 237 sorgt im Zusammenspiel mit dem Dämpfungsglied 138 dafür, dass der Zwangsauslöserhebel 234 nicht vor Ablauf der durch das Dämpfungsglied 238 vorgegebenen Verzögerungszeit in Entklinkungsrichtung verschwenkt wird.

Die Befestigungskralle 263 weist an ihrer der Koppelstange 239 zugewandten Seite eine Einführschräge 264 auf. Diese erleichtert das Aufsetzen des Stromzählers 216 auf die Aufnahmeplattform 214, wenn die Koppelstange 239 in den freien Raum innerhalb der Aufnahmeplattform 214 hineinragt.

Anstelle eines in der Figur 6 gezeigten einfachen Übertragungshebels kann auch eine komplexere mechanische Hebel - beziehungsweise Umlenkanordnung vorgesehen sein. Dies könnte beispielsweise dann erforderlich sein, wenn sich die Aufnahmeplattform 214 und die Unterbrechungsvorrichtung 230 in einem Zählerplatz nicht direkt untereinander befinden, sondern teilweise seitlich versetzt angeordnet sind.

Der Vorteil der erfindungsgemäßen Anordnung gemäß der Figur 6 besteht in der erhöhten Zuverlässigkeit der mechanischen Kopplung zwischen der Aufnahmeplattform und der Unterbrechungsvorrichtung 230.

Vorsorglich soll noch erwähnt werden, dass die Ausführungsformen gemäß der beschriebenen Figuren 1 bis 6 lediglich bevorzugte Ausführungsformen darstellen und den Gegenstand der vorliegenden Erfindung nicht auf die Ausführungsbeispiele beschränken.

**Bezugszeichenliste:**

| | |
|---|---|
| 10 | Stromzählersystem |
| 12 | Zählerkasten |
| 14,214 | Plattform |
| 141, 142 | Kontaktvorrichtung |
| 143 | Kontaktbrücke |
| 144 | Adaptergehäuse |
| 145 | Kontaktschlitze |
| 146 | Befestigungsschlitze |
| 16,216 | Stromzähler |
| 161, 162 | Kontaktfahnen |
| 163, 263 | Befestigungskrallen |
| 18 | Wand |
| 20 | Hausanschlusskasten |
| 22 | Hausanschlussleitung |
| 24 | Stromkreisverteiler |
| 26 | Verschiebeerkennungsvorrichtung |
| 30, 230 | Unterbrechungsvorrichtung |
| 32,232 | Trennschalter |
| 322 | Hohlwelle |
| 323 | Auslösehebel |
| 324 | Gehäuse |
| 325 | Schaltwerk |
| 326 | Schaltgriff |
| 327 | Kontakthebelarm |
| 328 | Kontaktstelle |
| 329 | Festes Kontaktstück |
| 330 | Bewegliches Kontaktstück |
| 331 | Auslöserschieber |
| 332, 333 | Zapfen |
| 332a, 333a | Erste Anlagefläche |
| 332b, 333b | Zweite Anlagefläche |
| 34 | Zwangsauslöser |
| 341, 341a | Auslösefinger |
| 342,242 | Rückstellvorrichtung |
| 234 | Zwangsauslöserhebel |
| 235 | Zwangsauslöserwelle |
| 236 | Freies Ende des Zwangsauslöserhebels |
| 237 | Rückstellfeder |
| 238 | Mechanisches Dämpfungsglied |
| 239 | Übertragungshebel |
| 40 | Fernwirkanschluss |
| 50 | Endschalter |
| 51 | Kontakthebel |
| 264 | Einführschräge |

## Patentansprüche

1. Stromzählersystem (10) mit einem elektronischen Stromzähler (16, 216) und einer Aufnahmeplattform (14, 214) für den Stromzähler (16, 216), und mit innerhalb der Plattform (14) angeordneten ersten Kontaktstücken (141, 142), die in einer Betriebsposition des Stromzählers (16, 216) mit Kontaktfahnen (161, 162) am Stromzähler (16, 216) in elektrisch leitender Verbindung stehen, und mit Überbrückungselementen (143) die, gesteuert von dem Stromzähler (16, 216), die ersten Kontaktstücke (142, 141) kurzschließen, wenn der Stromzähler (16, 216) sich in einer Montageposition befindet, **dadurch gekennzeichnet, dass** das Stromzählersystem (10) eine Unterbrechungsvorrichtung (30, 230) umfasst, die so mit der Aufnahmeplattform (14, 214) zusammenwirkt, dass bei Verschiebung des Stromzählers (16, 216) auf der Aufnahmeplattform (14, 214) aus der Betriebsposition in die Montageposition die Stromzufuhr zu der Aufnahmeplattform (14, 214) durch die Unterbrechungsvorrichtung (30, 230) bleibend unterbrochen wird.

2. Stromzählersystem (10) nach Anspruch 1, wobei die Unterbrechungsvorrichtung (30, 230) einen Trennschalter (32, 232) mit einem Schaltgriff (326) zum manuellen Ein - und Ausschalten des Trennschalters (32, 232) sowie mit einer Verklinkungsstelle umfasst.

3. Stromzählersystem (10) nach Anspruch 2, wobei die Aufnahmeplattform (14) eine Verschiebeerkennungsvorrichtung (26) und die Unterbrechungsvorrichtung (30) eine Zwangsauslösevorrichtung (34) umfasst, die durch die Verschiebeerkennungsvorrichtung (26) aus einer Einschalt- in eine Ausschaltstellung verbringbar ist, und die mit der Verklinkungsstelle des Trennschalters (32) so zusammenwirkt, dass diese in der Ausschaltstellung der Zwangsauslösevorrichtung (34) entklinkt ist.

4. Stromzählersystem (10) nach Anspruch 3, wobei der Trennschalter (32) so eingerichtet ist, dass bei durch die Zwangsauslösevorrichtung (34) entklinkter Verklinkungsstelle der Trennschalter (32) geöffnet ist und sich durch den Schaltgriff (326) nicht mehr schließen lässt.

5. Stromzählersystem (10) nach einem der vorigen Ansprüche, wobei die Unterbrechungsvorrichtung (30) so eingerichtet ist, dass die Unterbrechung der Stromzufuhr nur mithilfe spezieller Rücksetzmittel aufgehoben werden kann.

6. Stromzählersystem (10) nach Anspruch 5, wobei der Trennschalter (32) ein Sicherungshauptschalter ist.

7. Stromzählersystem (10) nach Anspruch 5, wobei der Trennschalter (32) ein Leitungsschutzschalter ist.

8. Stromzählersystem (10) nach einem der Ansprüche 3 bis 7, wobei die Zwangsauslösevorrichtung (34) ein Arbeitsstromauslöser ist, dessen Auslösefinger (341) mit der Verklinkungsstelle des Trennschalters (32) zusammenwirkt.

9. Stromzählersystem (10) nach Anspruch 8, wobei der Arbeitsstromauslöser nur mit einem Spezialwerkzeug manuell rücksetzbar ist.

10. Stromzählersystem (10) nach einem der Ansprüche 3 bis 7, wobei die Zwangsauslösevorrichtung (34) ein Stellantrieb ist, dessen angetriebene Achse mit der Verklinkungsstelle des Trennschalters zusammenwirkt.

11. Stromzählersystem (10) nach einem der Ansprüche 3 bis 10, wobei die Verschiebeerkennungsvorrichtung (26) einen Endschalter umfasst, der so angeordnet ist, dass er ein Verschiebeerkennungssignal an die Unterbrechungsvorrichtung (30) abgibt, wenn der Stromzähler (16) aus der Betriebsposition in die Montageposition verbracht ist.

12. Stromzählersystem (10) nach einem der Ansprüche 3 bis 11, wobei die Verschiebeerkenhungsvorrichtung (26) eine Lichtschranke umfasst, die so angeordnet ist, dass sie ein Verschiebeerkennungssignal an die Unterbrechungsvorrichtung (30) abgibt, wenn der Stromzähler (16) aus der Betriebsposition in die Montageposition verbracht ist.

13. Stromzählersystem (10) nach einem der Ansprüche 3 bis 12, wobei die Verschiebeerkennungsvorrichtung (26) eine Verzögerungsschaltung umfasst, so dass das Verschiebeerkennungssignal mit einer vorgebbaren zeitlichen Verzögerung, nachdem der Stromzähler (16) aus der Betriebsposition in die Montageposition verbracht wurde, an die Unterbrechungsvorrichtung (30) abgegeben wird.

14. Stromzählersystem (10) nach einem der vorigen Ansprüche, wobei über eine Fernwirkeinrichtung (40) das Verschiebeerkennungssignal an einen entfernten Ort und von dem entfernten Ort ein Unterbrechungssignal an die Unterbrechungsvorrichtung (30) übertragbar sind.

15. Stromzählersystem (10) nach Anspruch 14, wobei die Fernwirkeinrichtung (40) ein adressierbares und individuell ansprechbares, bidirektional wirkendes Zusatzgerät ist.

16. Stromzählersystem (10) nach Anspruch 14, wobei die Fernwirkeinrichtung (40) durch eine Zählerkommunikationseinheit des Stromzählers (16) gebildet ist.

17. Stromzählersystem (10) nach Anspruch 2, **dadurch gekennzeichnet, dass** die Aufnahmeplattform (214) und die Unterbrechungsvorrichtung (230) durch eine mechanische Kopplungsvorrichtung (239) verbunden sind, so dass bei einer Verschiebung des Stromzählers (216) aus seiner Betriebs - in die Montageposition die Verschiebebewegung des Stromzählers (216) mechanisch über einen ZHrangsauslöserhebel (234) auf die Verklinkungsstelle des Trennschalters (232) übertragen wird.

18. Stromzählersystem (10) nach Anspruch 17, wobei die mechanische Kopplungsvorrichtung (239) mit einem mechanischen Dämpfungsglied (238) zusammenwirkt, so das die Verschiebebewegung des Stromzählers (216) Zeit verzögert auf die Verklinkungsstelle des Trennschalters (232) übertragen wird.

19. Stromzählersystem (10) nach Anspruch 18, wobei eine Rückstellfeder (237) im Zusammenwirken mit dem Dämpfungsglied (238) auf den Zwangsauslöserhebel (234) so einwirkt, dass der Zwangsauslöserhebel (234) erst nach Ablauf einer durch das Dämpfungsglied (238) vorgegebenen Verzögerungszeit auf die Verklinkungsstelle des Trennschalters (232) wirken kann.

20. Stromzählersystem (10) nach Anspruch 2, wobei bei entklinkter Verklinkungsstelle der Trennschalter (32) geöffnet ist und sich durch den Schaltgriff (326) nicht mehr schließen lässt, sowie mit einem drehbar gelagerten Auslösehebel (323), der von einer Verklinkungs- in eine Entklinkungsstellung bringbar ist und in der Entklinkungsstellung die Verklinkungsstelle entklinkt, wobei der Auslösehebel (323) in seiner Drehachse eine Hohlwelle (322) aufweist, in die ein zwischen einer Ruhe - und einer Auslöseposition drehbarer Auslösefinger (341) des Zwangsauslösers (34) so einführbar ist, dass der Auslösehebel (323) des Trennschalters (32) in der Auslöseposition des Auslösefingers (341) in der Entkünkungssteilung gehalten ist.

21. Stromzählersystem (10) nach Anspruch 20, wobei die Innenkontur der Hohlwelle (322) und die Außenkontur des Auslösefingers (341) so miteinander korrespondieren, dass der Auslösefinger (341) des Zwangsauslösers (34) bei Verdrehen zwischen seiner Ruhe - und seiner Auslöseposition den Auslösehebel (323) in Richtung von dessen Entklinkungsstellung mitnimmt.

22. Stromzählersystem (10) nach Anspruch 21, wobei die Innenkontur der Hohlwelle (322) und die Außenkontur des Auslösefingers (341) so miteinander korrespondieren, dass der Auslösehebel (323) zwischen seiner Ver- und Entklinkungsstellung bewegbar ist, auch wenn der Auslösefinger (341) des Zwangsauslösers (34) sich in seiner Ruheposition befindet.

23. Stromzählersystem (10) nach Anspruch 22, wobei die Hohlwelle (322) radial nach innen weisende und sich radial gegenüberstehende Zapfen (332, 333 mit je einer ersten und einer zweiten, sich in Umfangesrichtung der Hohlwelle (322 gegenüberliegende Anlagefläche (322a, 333a; 322b, 333b) aufweist und der Auslösefinger (341) des Zwangsauslösers (34) in etwa die Form eines längs erstreckten Balkens hat.

24. Stromzählersystem (10) nach Anspruch 23, wobei der Auslösefinger (341) des Zwangsauslösers (34) beim Verdrehen zwischen der Ruhe - und Auslöseposition mit der ersten Anlagefläche (332a, 333a) der Zapfen (332,333) in kraftschlüssige Verbindung tritt, und wobei zwischen der zweiten Anlagefläche (332b, 333b) jedes Zapfens (332, 333) und dem Auslösefinger (341) in Umfangsrichtung der Hohlwelle (322) in der Ruheposition ein freier Raum besteht.

25. Stromzählersystem (10) nach Anspruch 1, wobei die Unterbrechungsvorrichtung (30) umfasst
a. einen Trennschalter (32) mit einem Schaltgriff (326) zum manuellen Ein - und Ausschalten des Trennschalters, und mit einer Verklinkungsstelle, wobei bei entklinkter Verklinkungsstelle der Trennschalter (32) geöffnet ist und sich durch den Schaltgriff (326) nicht mehr schließen lässt, sowie mit einem drehbar gelagerten Auslösehebel (323), der von einer Verklinkungs- in eine Entklinkungsstellung bringbar ist und in der Entklinkungsstellung die Verklinkungsstelle entklinkt, wobei der Auslösehebel (323) in seiner Drehachse eine Hohlwelle (322) aufweist,
b. und einen Zwangsauslöser (34) mit einem zwischen einer Ruhe- und einer Auslöseposition drehbaren Auslösefinger (341),
c. wobei der Trennschalter (32) und der Zwangsauslöser (34) aneinander gereiht sind, so dass der Auslösefinger (341) in die Hohlwelle (322) des Auslösehebel (323) eingreift und so mit dieser zusammenwirkt, dass der Auslösehebel (323) des Trennschalters (32) in der Auslöseposition des Auslösefingers in der Entklinkungsstellung gehalten ist.

26. Stromzählersystem (10) nach Anspruch 25, wobei der Trennschalter (32) ein einpoliger Sicherungshauptschalter und der Zwangsauslöser (34) ein Arbeitsstromauslöser ist.

27. Stromzählersystem (10) nach Anspruch 25, wobei der Trennschalter (32) ein aus mehreren aneinander gereihten Einzelpolen gebildeter mehrpoliger Sicherungshauptschalter ist und der Auslösefinger (341) des Zwangsauslösers (34) mit den Hohlwellen (322) in den Auslösehebeln jedes Pols zusammenwirkt.

28. Stromzählersystem (10) nach Anspruch 25, wobei der Trennschalter (32) ein einzelner, mehrpoliger Sicherungshauptschalter ist und der Auslösefinger (341) des Zwangsauslösers (34) mit der Hohlwelle (322) in dem Auslösehebel nur eines Poles des mehrpoligen Sicherungshauptschalters zusammenwirkt.

## Claims

1. Electricity meter system (10) having an electronic electricity meter (16, 216) and a mounting platform (14, 214) for the electricity meter (16, 216), and having first contact elements (141, 142) which are arranged inside the platform (14) and in an operating position of the electricity meter (16, 216) are connected in an electrically conductive fashion to contact lugs (161, 162) on the electricity meter (16, 216), and having bypass elements (143) which, under the control of the electricity meter (16, 216), short-circuit the first contact elements (142, 141) when the electricity meter (16, 216) is in an installation position, **characterized in that** the electricity meter system (10) comprises an interrupter device (30, 230) which interacts with the mounting platform (14, 214) in such a way that, when the electricity meter (16, 216) on the mounting platform (14, 214) is moved out of the operating position into the installation position, the supply of electricity to the mounting platform (14, 214) is permanently interrupted by the interrupt device (30, 230).

2. Electricity meter system (10) according to Claim 1, wherein the interrupter device (30, 230) comprises a circuit breaker (32, 232) with a switching handle (326) for manually switching the circuit breaker (32, 232) on and off, and having a latching point.

3. Electricity meter system (10) according to Claim 2, wherein the mounting platform (14) comprises a displacement-detection device (26) and the interrupter device (30) comprises a forced triggering device (34) which can be moved from a switch-on position into a switch-off position by the displacement-detection device (26), and which interacts with the latching point of the circuit breaker (32) in such a way that in the switch-off position said latching point is disengaged from the forced triggering device (34).

4. Electricity meter system (10) according to Claim 3, wherein the circuit breaker (32) is configured in such a way that, in the case of a latching point which is disengaged by the forced triggering device (34), the circuit breaker (32) is opened and can no longer be closed by the switching handle (326).

5. Electricity meter system (10) according to one of the preceding claims, wherein the interrupter device (30) is configured in such a way that the interruption of the power supply can be cancelled only by using special resetting means.

6. Electricity meter system (10) according to Claim 5, wherein the circuit breaker (32) is a main fused switch.

7. Electricity meter system (10) according to Claim 5, wherein the circuit breaker (32) is a line circuit breaker.

8. Electricity meter system (10) according to one of Claims 3 to 7, wherein the forced triggering device (34) is a working current trigger whose triggering finger (341) interacts with the latching point of the circuit breaker (32).

9. Electricity meter system (10) according to Claim 8, wherein the working current trigger can be reset manually only with a special tool.

10. Electricity meter system (10) according to one of Claims 3 to 7, wherein the forced triggering device (34) is an actuator drive whose driven axle interacts with the latching point of the circuit breaker.

11. Electricity meter system (10) according to one of Claims 3 to 10, wherein the displacement-detection device (26) comprises a limit switch which is arranged in such a way that it outputs a displacement-detection signal to the interrupter device (30) if the electricity meter (16) is moved out of the operating position into the installation position.

12. Electricity meter system (10) according to one of Claims 3 to 11, wherein the displacement-detection device (26) comprises a photo-electric barrier which is arranged in such a way that it outputs a displacement-detection signal to the interrupter device (30) if the electricity meter (16) is moved out of the operating position into the installation position.

13. Electricity meter system (10) according to one of Claims 3 to 12, wherein the displacement-detection device (26) comprises a delay circuit so that the displacement-detection signal is output to the interrupter device (30) with a predefined delay after the electricity meter (16) has been moved out of the operating position into the installation position.

14. Electricity meter system (10) according to one of the preceding claims, wherein, by means of a remote control device (40), the displacement-detection signal can be transmitted to a remote location, and an interrupt signal can be transmitted from the remote location to the interrupter device (30).

15. Electricity meter system (10) according to Claim 14, wherein the remote control device (40) is a bidirectionally acting accessory device which can be addressed and is individually addressable.

16. Electricity meter system (10) according to Claim 14, wherein the remote control device (40) is formed by a meter communication unit of the electricity meter (16).

17. Electricity meter system (10) according to Claim 2, **characterized in that** the mounting platform (214) and the interrupter device (230) are connected by a mechanical coupling device (239), with the result that when the electricity meter (216) is moved out of its operating position into the installation position, the displacement movement of the electricity meter (216) is transmitted mechanically to the latching point of the circuit breaker (232) via a forced triggering lever (234).

18. Electricity meter system (10) according to Claim 17, wherein the mechanical coupling device (239) interacts with a mechanical damping element (238) with the result that the displacement movement of the electricity meter (216) is transmitted with a delay to the latching point of the circuit breaker (232).

19. Electricity meter system (10) according to Claim 18, wherein a resetting spring (237) acts together with the damping element (238) on the forced triggering lever (234) in such a way that the forced triggering lever (234) cannot act on the latching point of the circuit breaker (232) until after the expiry of a delay time predefined by the damping element (238).

20. Electricity meter system (10) according to Claim 2, wherein, when the latching point is disengaged, the circuit breaker (32) is opened and can no longer be closed by the switching handle (326), and having a rotatably mounted triggering lever (323) which can be moved from a latching position into a disengagement position, and in the disengagement position disengages the latching point, wherein the triggering lever (323) has, in its rotational axis, a hollow shaft (322) into which a triggering finger (341), rotatable between a position of rest and a triggering position, of the forced trigger (34) can be introduced in such a way that in the triggering position of the triggering finger (341) the triggering lever (323) of the circuit breaker (32) is held in the disengagement position.

21. Electricity meter system (10) according to Claim 20, wherein the internal contour of the hollow shaft (322) and the external contour of the triggering finger (341) correspond to one another in such a way that as it rotates between its position of rest and its triggering position the triggering finger (341) of the forced trigger (34) entrains the triggering lever (323) in the direction of its disengagement position.

22. Electricity meter system (10) according to Claim 21, wherein the internal contour of the hollow shaft (322) and the external contour of the triggering finger (341) correspond to one another in such a way that the triggering lever (323) can be moved between its latching position and its disengagement position even if the triggering finger (341) of the forced trigger (34) is located in its position of rest.

23. Electricity meter system (10) according to Claim 22, wherein the hollow shaft (322) has radially inwardly pointing pins (332, 333) which are located radially opposite one another and each have a first and a second bearing face (322a, 333a; 322b, 333b) which lie opposite one another in the circumferential direction of the hollow shaft (322), and the triggering finger (341) of the forced trigger (34) is approximately in the shape of a longitudinally extended bar.

24. Electricity meter system (10) according to Claim 23, wherein the triggering finger (341) of the forced trigger (34) enters, during the rotation between the position of rest and the triggering position, into a frictionally locking connection with the first bearing face (332a, 333a) of the pins (332, 333), and wherein there is a free space between the second bearing face (332b, 333b) of each pin (332, 333) and the triggering finger (341) in the circumferential direction of the hollow shaft (322) in the position of rest.

25. Electricity meter system (10) according to Claim 1, wherein the interrupter device (30) comprises
a. a circuit breaker (32) with a switching handle (326) for manually switching the circuit breaker on and off, and having a latching point, wherein, when the latching point is disengaged, the circuit breaker (32) is opened and can no longer be closed by the switching handle (326), as well as having a rotatably mounted triggering lever (323) which can be moved from a latching position into a disengagement position and in the disengagement position disengages the latching point, wherein the triggering lever (323) has a hollow shaft (322) in its rotational axis,
b. and a forced trigger (34) with a triggering finger (341) which can be rotated between a position of rest and a triggering position,
c. wherein the circuit breaker (32) and the forced trigger (34) are arranged one adjacent to the other in series with the result that the triggering finger (341) engages in the hollow shaft (322) of the triggering lever (323) and interacts therewith in such a way that, in the triggering position of the triggering finger, the triggering lever (323) of the circuit breaker (32) is held in the disengagement position.

26. Electricity meter system (10) according to Claim 25, wherein the circuit breaker (32) is a unipolar main fused switch, and the forced trigger (34) is a working current trigger.

27. Electricity meter system (10) according to Claim 25, wherein the circuit breaker (32) is a multi-pole main fused switch which is formed from individual poles which are arranged one adjacent to the other in series, and the triggering finger (341) of the forced trigger (34) interacts with the hollow shafts (322) in the trigger levers of each pole.

28. Electricity meter system (10) according to Claim 25, wherein the circuit breaker (32) is an individual, multi-pole main fused switch, and the triggering finger (341) of the forced trigger (34) interacts with the hollow shaft (322) in the trigger lever of just one pole of the multi-pole main fused switch.

## Revendications

1. Système compteur d'électricité (10) comprenant un compteur d'électricité électronique (16, 216) et une plate-forme d'accueil (14, 214) pour le compteur d'électricité (16, 216) et comprenant des premiers éléments de contact (141, 142) disposés à l'intérieur de la plate-forme (14), lesquels, dans une position opérationnelle du compteur d'électricité (16, 216), sont en liaison électriquement conductrice avec des queues de contact (161, 162) sur le compteur d'électricité (16, 216), et comprenant des éléments de pontage (143) qui, commandés par le compteur d'électricité (16, 216), court-circuitent les premiers éléments de contact (142, 141) lorsque le compteur d'électricité (16, 216) se trouve dans une position de montage, **caractérisé en ce que** le système compteur d'électricité (10) comprend un dispositif d'interruption (30, 230) qui interagit avec la plate-forme d'accueil (14, 214) de telle sorte qu'en cas de translation du compteur d'électricité (16, 216) sur la plate-forme d'accueil (14, 214) depuis la position opérationnelle dans la position de montage, l'arrivée de courant vers la plate-forme d'accueil (14, 214) est interrompue de manière permanente par le dispositif d'interruption (30, 230).

2. Système compteur d'électricité (10) selon la revendication 1, avec lequel le dispositif d'interruption (30, 230) comprend un sectionneur (32, 232) muni d'une poignée de commande (326) pour la mise en circuit et hors circuit manuelle du sectionneur (32, 232) ainsi qu'un point d'encliquetage:

3. Système compteur d'électricité (10) selon la revendication 2, avec lequel la plate-forme d'accueil (14) comprend un dispositif de détection de translation (26) et le dispositif d'interruption (30) un dispositif de déclenchement forcé (34) qui peut être amené par le dispositif de détection de translation (26) d'une position de mise en circuit en une position de mise hors circuit, et qui interagit avec le point d'encliquetage du sectionneur (32) de telle sorte que celui-ci est désencliqueté dans la position de mise hors circuit du dispositif de déclenchement forcé (34).

4. Système compteur d'électricité (10) selon la revendication 3, avec lequel le sectionneur (32) est configuré de telle sorte que lorsque le point d'encliquetage est désencliqueté par le dispositif de déclenchement forcé (34), le sectionneur (32) est ouvert et ne peut plus être fermé par la poignée de commande (326).

5. Système compteur d'électricité (10) selon l'une des revendications précédentes, avec lequel le dispositif d'interruption (30) est configuré de telle sorte que l'interruption de l'arrivée du courant ne peut être annulée qu'à l'aide de moyens de réarmement spéciaux.

6. Système compteur d'électricité (10) selon la revendication 5, avec lequel le sectionneur (32) est un disjoncteur général.

7. Système compteur d'électricité (10) selon la revendication 5, avec lequel le sectionneur (32) est un contacteur de ligne.

8. Système compteur d'électricité (10) selon l'une des revendications 3 à 7, avec lequel le dispositif de déclenchement forcé (34) est un déclencheur à courant de travail dont la languette de déclenchement (341) interagit avec le point d'encliquetage du sectionneur (32).

9. Système compteur d'électricité (10) selon la revendication 8, avec lequel le déclencheur à courant de travail ne peut être réarmé que manuellement avec un outil spécial.

10. Système compteur d'électricité (10) selon l'une des revendications 3 à 7, avec lequel le dispositif de déclenchement forcé (34) est un servomoteur dont l'axe mené interagit avec le point d'encliquetage du sectionneur.

11. Système compteur d'électricité (10) selon l'une des revendications 3 à 10, avec lequel le dispositif de détection de translation (26) comprend un fin de course qui est disposé de telle sorte qu'il délivre un signal de détection de translation au dispositif d'interruption (30) lorsque le compteur d'électricité (16) est amené depuis la position opérationnelle dans la position de montage.

12. Système compteur d'électricité (10) selon l'une des revendications 3 à 11, avec lequel le dispositif de détection de translation (26) comprend une barrière photoélectrique qui est disposée de telle sorte qu'elle délivre un signal de détection de translation au dispositif d'interruption (30) lorsque le compteur électrique (16) est amené depuis la position opérationnelle dans la position de montage.

13. Système compteur d'électricité (10) selon l'une des revendications 3 à 12, avec lequel le dispositif de détection de translation (26) comprend un circuit de retard de sorte que le signal de détection de translation soit délivré au dispositif d'interruption (30) avec un retard dans le temps pouvant être prédéfini après que le compteur d'électricité (16) ait été amené depuis la position opérationnelle dans la position de montage.

14. Système compteur d'électricité (10) selon l'une des revendications précédentes, avec lequel le signal de détection de translation peut être transmis par le biais d'un dispositif d'action à distance (40) à un site distant et un signal d'interruption peut être transmis depuis le site distant au dispositif d'interruption (30).

15. Système compteur d'électricité (10) selon la revendication 14, avec lequel le dispositif d'action à distance (40) est un appareil supplémentaire à effet bidirectionnel, adressable et pouvant être invoqué individuellement.

16. Système compteur d'électricité (10) selon la revendication 14, avec lequel le dispositif d'action à distance (40) est formé par une unité de communication de compteur du compteur d'électricité (16).

17. Système compteur d'électricité (10) selon la revendication 2, **caractérisé en ce que** la plate-forme d'accueil (214) et le dispositif d'interruption (230) sont reliés par un dispositif d'accouplement mécanique (239), de telle sorte qu'en cas de translation du compteur d'électricité (216) depuis la position opérationnelle dans la position de montage, le mouvement de translation du compteur d'électricité (216) est transmis mécaniquement au point d'encliquetage du sectionneur (232) par le biais d'un levier de déclenchement forcé (234).

18. Système compteur d'électricité (10) selon la revendication 17, avec lequel le dispositif d'accouplement mécanique (239) interagit avec un élément amortisseur mécanique (238) de telle sorte que le mouvement de translation du compteur d'électricité (216) est transmis avec un retard dans le temps au point d'encliquetage du sectionneur (232).

19. Système compteur d'électricité (10) selon la revendication 18, avec lequel un ressort de rappel (237) agit sur le levier de déclenchement forcé (234) lors de l'interaction avec l'élément amortisseur (238) de telle sorte que le levier de déclenchement forcé (234) ne peut agir sur le point d'encliquetage du sectionneur (232) qu'après écoulement d'un temps de retard prédéfini par l'élément amortisseur (238).

20. Système compteur d'électricité (10) selon la revendication 2, avec lequel lorsque le point d'encliquetage est désencliqueté, le sectionneur (32) est ouvert et ne peut plus être fermé par la poignée de commande (326), et comprenant aussi un levier de déclenchement (323) monté de manière rotative qui peut être amené d'une position d'encliquetage en une position de désencliquetage et qui désencliquète le point d'encliquetage en position de désencliquetage, le levier de déclenchement (323) présentant dans son axe de rotation un arbre creux (322) dans lequel une languette de déclenchement (341) du déclencheur forcé (34), qui peut être pivotée entre une position de repos et une position de déclenchement, peut être introduite de telle sorte que le levier de déclenchement (323) du sectionneur (32), dans la position de déclenchement de la languette de déclenchement (341), est maintenu dans la position de désencliquetage.

21. Système compteur d'électricité (10) selon la revendication 20, avec lequel le profil intérieur de l'arbre creux (322) et le profil extérieur de la languette de déclenchement (341) correspondent mutuellement de telle sorte que la languette de déclenchement (341) du déclencheur forcé (34), lors d'une rotation entre sa position de repos et sa position de déclenchement, entraîne le levier de déclenchement (323) en direction de sa position de désencliquetage.

22. Système compteur d'électricité (10) selon la revendication 21, avec lequel le profil intérieur de l'arbre creux (322) et le profil extérieur de la languette de déclenchement (341) correspondent mutuellement de telle sorte que le levier de déclenchement (323) peut être déplacé entre sa position d'encliquetage et sa position de désencliquetage même lorsque la languette de déclenchement (341) du déclencheur forcé (34) se trouve dans sa position de repos.

23. Système compteur d'électricité (10) selon la revendication 22, avec lequel l'arbre creux (322) présente des tenons (332, 333) orientés vers l'intérieur et mutuellement face à face dans le sens radial comprenant chacun une première et une deuxième surface d'appui (322a, 333a ; 322b, 333b) mutuellement opposées dans le sens du pourtour de l'arbre creux (322) et la languette de déclenchement (341) du déclencheur forcé (34) présente approximativement la forme d'une poutrelle étendue en longueur.

24. Système compteur d'électricité (10) selon la revendication 23, avec lequel la languette de déclenchement (341) du déclencheur forcé (34), lors d'une rotation entre la position de repos et la position de déclenchement, entre en liaison d'adhérence avec la première surface d'appui (332a, 333a) des tenons (332, 333) et avec lequel il existe en position de repos un espace libre entre la deuxième surface d'appui (332b, 333b) de chaque tenon (332, 333) et la languette de déclenchement (341) dans le sens du pourtour de l'arbre creux (322).

25. Système compteur d'électricité (10) selon la revendication 1, avec lequel le dispositif d'interruption (30) comprend
a. un sectionneur (32) muni d'une poignée de commande (326) pour la mise en circuit et hors circuit manuelle du sectionneur et comprenant un point d'encliquetage, le sectionneur (32) étant ouvert lorsque le point d'encliquetage est désencliqueté et ne pouvant plus être fermé par la poignée de commande (326), et comprenant aussi un levier de déclenchement (323) monté de manière rotative qui peut être amené d'une position d'encliquetage en une position de désencliquetage et qui désencliquète le point d'encliquetage en position de désencliquetage, le levier de déclenchement (323) présentant dans son axe de rotation un arbre creux (322),
b. et un déclencheur forcé (34) muni d'une languette de déclenchement (341) qui peut être pivotée entre une position de repos et une position de déclenchement,
c. le sectionneur (32) et le déclencheur forcé (34) étant montés l'un à la suite de l'autre de telle sorte que la languette de déclenchement (341) vient en prise dans l'arbre creux (322) du levier de déclenchement (323) et interagit ainsi avec lui de telle sorte que le levier de déclenchement (323) du sectionneur (32) soit maintenu dans la position de désencliquetage lorsque la languette de déclenchement se trouve en position de déclenchement.

26. Système compteur d'électricité (10) selon la revendication 25, avec lequel le sectionneur (32) est un disjoncteur général unipolaire et le déclencheur forcé (34) est un déclencheur à courant de travail.

27. Système compteur d'électricité (10) selon la revendication 25, avec lequel le sectionneur (32) est un disjoncteur général multipolaire constitué de plusieurs pôles individuels montés les uns à la suite des autres et la languette de déclenchement (341) du déclencheur forcé (34) interagit avec les arbres creux (322) dans les leviers de déclenchement de chaque pôle.

28. Système compteur d'électricité (10) selon la revendication 25, avec lequel le sectionneur (32) est un disjoncteur général multipolaire unique et la languette de déclenchement (341) du déclencheur forcé (34) interagit avec l'arbre creux (322) dans le levier de déclenchement d'un seul pôle du disjoncteur général multipolaire.
